(19) Europäisches Patentamt
European Patent Office
Office européen des brevets

(11) EP 0 480 674 B1

(12) **EUROPEAN PATENT SPECIFICATION**

(45) Date of publication and mention
of the grant of the patent:
**15.07.1998 Bulletin 1998/29**

(51) Int Cl.⁶: **H04L 27/20**

(21) Application number: **91309208.6**

(22) Date of filing: **08.10.1991**

(54) **Binary phase shift key modulator**

Modulator für binäre Phasensprungmodulation

Modulateur binaire à déplacement de phase

(84) Designated Contracting States:
**DE ES FR GB IT SE**

(30) Priority: **08.10.1990 KR 1594090**

(43) Date of publication of application:
**15.04.1992 Bulletin 1992/16**

(73) Proprietor: **SAMSUNG ELECTRONICS CO., LTD.**
**Suwon-City, Kyounggi-Do 441-370 (KR)**

(72) Inventor: **Cheon, Byoung-Jin**
**Suwon-city, Kyounggi-do (KR)**

(74) Representative: **Stanley, David William et al**
**APPLEYARD LEES**
**15 Clare Road**
**Halifax West Yorkshire HX1 2HY (GB)**

(56) References cited:
**FR-A- 2 462 816**          **US-A- 3 378 637**
**US-A- 3 699 479**          **US-A- 4 748 641**

• **INTERNATIONAL JOURNAL OF ELECTRONICS**
**vol. 59, no. 3, September 1985, LONDON GB**
• **pages 391 - 395 R.S. FYATH ET AL.: 'Generation**
**of constant-envelope signals using a sine-wave**
**crossing technique.'**

## Description

The present invention relates generally to modulation circuits, and is concerned particularly with Biphase Shift Keying (BPSK) modulation for digital telecommunication systems.

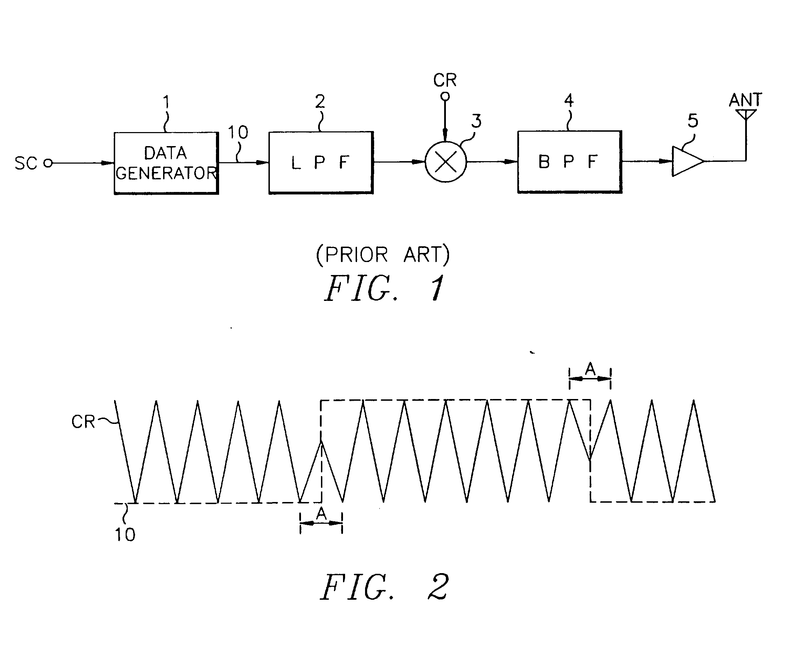

A known BPSK modulator together with its transmission circuitry is disclosed in Figure 1 of the accompanying diagrammatic drawings, and comprises a data generator 1 providing a given digital signal, a low-pass filter (LPF) 2 suppressing high-frequency components of the digital signal, and a modulator 3 for modulating in phase the filtered output from the LPF into a carrier-wave signal as shown in Figure 2 of the accompanying diagrammatic drawings, which shows a waveform of the modulated output signal from the modulator 3. This modulated signal is delivered to a band-pass filter (BPF) 4 and then amplified in a C-class power amplifier 5. An antenna (ANT) receives the amplified signal for transmission into the air.

This type of BPSK modulator, as shown in Figure 1, adopts a modulation system in which a phase of the carrier-wave (CR) is instantaneously shifted by 0° and 180° in dependence upon the digital signal from the data generator, during modulation of the digital signal to the carrier-wave. Thus, when the carrier-wave (CR) passes through the BPF, there occur phenomena that its amplitude decreases at a given zero-crossing position, as shown by reference symbol A in Figure 2, during the shifting of the carrier-wave by 0° and 180°. This is because the frequency in the zero-crossing position becomes outside a passing frequency band in the BPF. Therefore, in the power amplifier 5, operating at C-class level, adequate amplification of the modulated signal may not be provided at the zero-crossing positions, thereby resulting in distortion of output signals.

US 3,699,479 (Thompson) discloses a differential phase shift keying modulation system comprising data conversion means, connected to receive incoming serial data, for providing an in-phase signal component and a quadra-phase signal component and a modulation means, connected to receive both the in-phase and quadra-phase signal components from the data conversion means, for providing a phase modulation system of constant envelope on a given carrier wave signal for the data transmission. Figure 1 of this citation shows an embodiment incorporating a pulse source which is controlled by digital logic means to supply pulses to a frequency modulator via an up/down counting unit to a ring counter. The up/down counting unit determines the direction of counting under control of the digital logic means and the ring counter outputs are weighted and supplied to balanced modulators via low pass filters. The outputs from the modulators are combined and the resultant fed to an output terminal.

Preferred embodiments of the present invention aim to provide a BPSK modulation circuit capable of preventing signal distortion in the vicinity of phase shift upon a power amplification of a modulation signal by providing a constant envelope characteristic to the modulation signal during the BPSK modulation.

According to a first aspect of the present invention, there is provided a biphase shift keying (BPSK) modulation circuit for a digital data transmission system, the circuit comprising:

a clock input for receiving a system clock; data generation means for providing digital data in synchronism with the system clock; data conversion means, connected to receive the system clock and the digital data from the data generation means to produce both in-phase and quadra-phase signal components from the digital data; and modulation means, for providing a phase modulation signal of constant envelope on a given carrier wave signal for digital data transmission, the circuit being characterised in that the digital data from the data generation means are random digital data from a random data generation means, the data conversion means comprises a shift register connected to receive the system clock and the digital data, for providing in parallel a plurality of digital data sequentially shifted from the digital data of the data generation means in synchronism with the system clock, a first resistance array, connected to receive the parallel digital data from said shift register, for providing an in-phase signal component produced in dependence upon multiplication and adding operations therein, said first resistance array having a plurality of resistors each coupled to corresponding ones of outputs of said shift register, a gate array having a plurality of logic gates, each gate being connected to receive a pair of selected two inputs of said shift register, and a second resistance array connected to receive an output of said gate array, for providing a quadra-phase signal component produced in dependence upon multiplication and adding operations therein, said second resistance array having a plurality of resistors each coupled to corresponding ones of the logic gates of said gate array, and said in-phase signal component is processed by said modulation means in double-balanced modulation with the carrier-wave and said quadra-phase signal component is processed in single-balanced modulation with a phase-shifted signal of the carrier-wave, and said double-balanced modulation signal and said single-balanced modulation signal are added to each other.

Preferably, said logic gates each comprise an EXCLUSIVE-OR logic gate.

Preferably, said modulation means comprises:

a first multiplier connected to receive the in-phase signal component, for providing a double-balanced modulation component on the basis of the carrier-wave;

a phase shifter connected to receive the carrier-wave for phase shifting the carrier-wave;

a second multiplier connected to receive the quadra-phase signal component, for providing a single-balanced modulation component on the basis of the phased-shifted carrier-wave; and

an adder connected to add both the outputs of the first and second multipliers, for producing therefrom a resultant biphase shift keying modulation signal.

A BPSK modulation circuit as above may further comprise an amplifier for amplifying the biphase shift keying modulation signal from said modulation means.

A BPSK modulation circuit as above may further comprise an antenna device coupled to the amplifier, for transmission of the modulation signal into the air.

Preferably, said amplifier is of a C-class operation mode.

Preferably, said phase shifter is arranged to perform a 90-degrees phase shifting operation on an input signal.

Preferably, each resistance of said first and second resistance arrays is arranged to meet the following relationship:

$$[I(t)]^2 + [Q(t)]^2 = C$$

wherein,

I(t) represents the in-phase signal component,
Q(t) represents the quadra-phase signal component, and
C is a given constant.

A BPSK modulation circuit as above may further comprise a carrier-wave generation means connected to said modulation means for providing the carrier-wave.

The invention extends to a digital data transmission system provided with a modulation circuit in accordance with the abovementioned aspect.

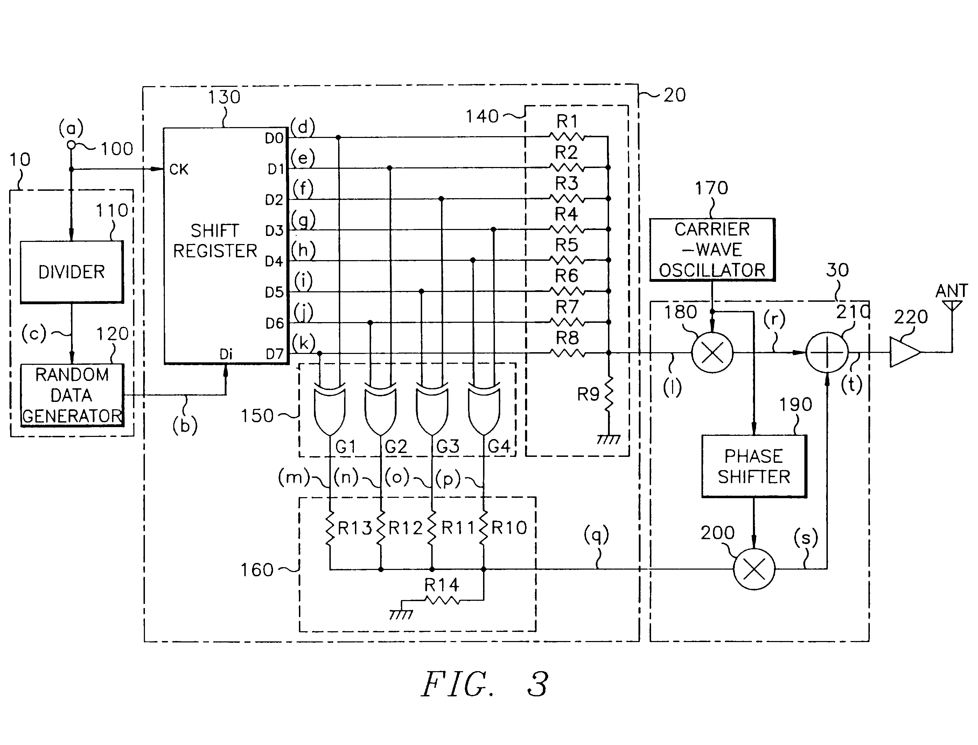

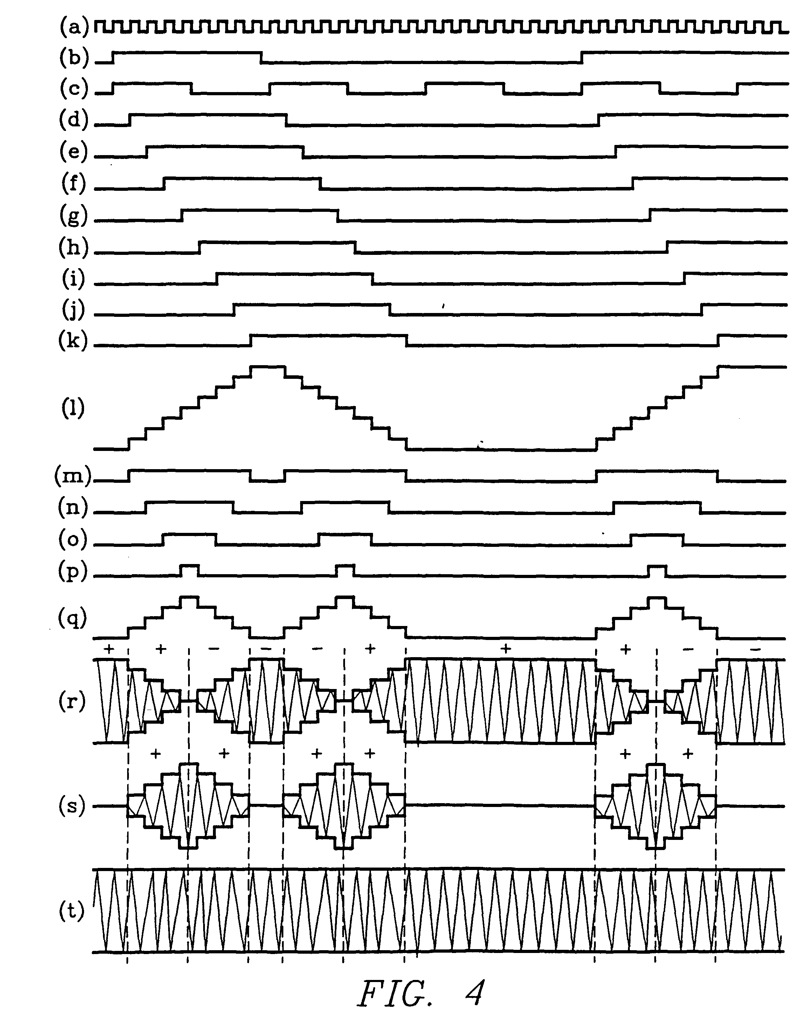

For a better understanding of the invention, and to show how the same may be carried into effect, reference will now be made, by way of example, to Figures 3 and 4 of the accompanying diagrammatic drawings, in which:

Figure 3 is a schematic block diagram indicating one example of a preferred embodiment of a BPSK modulation circuit according to the present invention; and

Figures 4(a) to 4(t) are waveform and timing diagrams for illustrating examples of stages of operation of the modulation circuit of Figure 3.

Referring to Figure 3, the illustrated BPSK modulation circuit has a clock input 100, a data generator circuit 10, a data converter circuit 20, a carrier-wave oscillator 170, a modulation circuit 30, an amplifier 220 in C-class, and an antenna (ANT). The clock input 100 receives a system clock. The data generator 10 is connected to receive the system clock, divide it, and provide therefrom random digital data in synchronism with the system clocks. The data converter 20 is connected to receive the system clock and an output of the data generator 10, and is arranged to provide an in-phase signal component and a quadra-phase signal component in synchronism with the system clock. The in-phase and quadra-phase signal components may be of step waveform.

The modulation circuit 30 is connected to receive both the in-phase and quadra-phase signal components from the data converter 20, to provide a phase modulation signal of constant envelope on a given carrier-wave signal for the digital data transmission. The in-phase signal component is processed in double-balanced modulation with the carrier-wave, and the quadra-phase signal component is processed in single-balanced modulation with a phase-shifted signal of the carrier-wave, and both the double-balanced modulation signal and the single-balanced modulation signal are added to each other.

The amplifier 220 receives an output of the modulation circuit 30 to amplify the output received therefrom in C-class operation mode. The antenna ANT is coupled to receive the amplified output of the amplifier 220 for irradiation of the transmission signal into the air.

The data generator 10 is constructed with a divider 110 receiving the system clock to provide therefrom a divided clock, and a random data generator 120 coupled to receive the divided clock, for providing given random digital data.

The data converter 20 includes a shift register 130 connected to receive the system clock and the random digital data, for providing in parallel a plurality of digital data sequentially shifted from the random digital data in synchronism with the system clock, and a first resistance array 140 connected to receive the parallel digital data from the shift register, for providing the in-phase signal component produced in dependence upon multiplication and adding operations therein, wherein the first resistance array 140 has a plurality of resistors each coupled to corresponding ones of outputs of the shift register 130. A gate array 150 has a plurality of logic gates, each gate being connected to receive a pair of selected two outputs of the shift register 130, and a second resistance array 160 is connected to receive an output of the gate array 150, for providing the quadra-phase signal component produced in dependence upon multiplication and adding operations therein, wherein the second resistance array 160 has a plurality of resistors each coupled to corresponding ones of the logic gates of the gate array 150.

The first and second resistance arrays 140 and 160 each include a respective series of a plurality of resistors R1-R9 and R10-R14, and the gate array 150 includes a plurality of logic gates G1 to G4.

Referring to Figures 4(a) to 4(t), various timing diagrams illustrating examples of every operation stage of the circuit of Figure 3, are indicated. In the drawing of Figures 4(a) to 4(t), (a) shows a system clock, (b) an output waveform of the random data generator 120, (c) a waveform divided from the system clock (a) by the divider 110, and (d) to (k) waveforms provided by a shift operation of the waveform (c) in the shift register 130 in accordance with the system clock (a). Further, (1) shows an in-phase data waveform as an output of the first resistance array 140 which processes adding of the outputs (d) to (k) from the shift register 130, (m) a waveform of EXCLUSIVE-ORing operation of the waveforms (d) and (k), (n) a waveform of EXCLUSIVE-ORing operation of the waveforms (e) and (j), (o) a waveform of EXCLUSIVE-ORing operation of the waveforms (f) and (i), (p) a waveform of EXCLUSIVE-ORing operation of the waveforms (g) and (h), and (q) a quadra-phase data waveform as an output of the second resistance array 160 which processes adding of the outputs (m) to (p) of the EXCLUSIVE-OR gates G1 to G4. Furthermore, (r) shows a waveform multiplied by a carrier-wave of the in-phase waveform (l), (s) a waveform multiplied by an output of the phase shifter 190 which shifts in 90° the phase of the carrier wave, of the quadra-phase data waveform (q), and (t) a modulation output signal resulting from adding of the waveforms (r) and (s).

Referring to the above-described construction, an example of operation of the BPSK modulation will be described in further detail, hereinafter.

Once a system clock (a) is applied through the clock input 100 to the divider 110 in the data generator section 10, the system clock is divided by a given ratio, as shown in the waveform of Figure 4(c). The random data generator 120 receives an output (c) of the divider to therefrom provide random digital data shown in Figure 4(b). The shift register 130 receives at its clock terminal the system clock (a) and the output (b) of the random data generator 120 to provide therefrom at its output (D0-D7) a series of shifted digital data, as shown in Figures 4(d) - 4(k). Here, the output data (d) in D0 output is a digital signal delayed by one clock period time of the output (b) of the random data generator 120, the output data (e) in D1 output is a digital signal delayed by one clock period time of the Do output data (d), and the output data (f) in D2 output is likewise a digital signal delayed by the same clock period of the D1 output data (e). Other remaining output data (g)-(k) in the D3-D7 output of the shift register 130 are provided likewise by a similar shifting operation from a preceding stage. As a result, the output data in the D7 output is obtained by delaying 8 times the output random data (b) of the random data generator. All of the input/output operation in the shift register 130 is adapted to be synchronized with the system clock (a) from the clock input 100.

The first resistance array 140 receives a series of the shifted digital data from the shift register 130, which digital data are multiplied by a corresponding resistance value by means of a corresponding resistor R1 to R8 each coupled to a respective output of the shift register 130 and thereafter are added up altogether to produce therefrom an in-phase signal as shown in Figure 4(l). Further, the gate array 150, coupled to the second resistance array 160, also receives the digital data output from the shift register 130, and then performs an EXCLUSIVE-OR operation to selected two outputs, for example, a pair of D0 and D7, or D1 and D6, of the series of shifted digital data in the outputs D0 and D7. The second resistance array 160 having a series of resistors R10 to R13 receives corresponding outputs (m) to (p) of the gate array 150 to multiply the same outputs each by a corresponding resistance and to produce a resultant quadra-phase signal by adding together all of the multiplied outputs of the respective resistors R10 to R13.

Here, assuming that the in-phase signal is represented by I(t) and the quadra-phase signal is represented by Q(t), there should be kept a relation of $[I(t)]^2 + [Q(t)]^2 = C$, wherein C is a constant, in order to obtain a constant envelope characteristic for a BPSK modulation signal subsequent to a given modulation. Thus, it would be well understood to the worker skilled in the art that such a relation will be easily able to be obtained by arranging the corresponding resistance values or combination thereof in the first and second resistance arrays 140 and 160.

The carrier-wave oscillator 170 provides a carrier-wave to the first multiplier 180, which multiplies the carrier-wave by the output (l) of the first resistance array 140 to produce therefrom a double-balanced modulation signal as shown by the waveform of Figure 4(r). Further, the second multiplier 200 receives an output of the phase shifter 190, which output is multiplied by the output (g) of the second resistance array (160) to produce therefrom a single-balanced modulation signal as shown by the waveform of Figure 4(s). Here, the adder 210 adds the output (r) of the first multiplier 180 to the output (s) of the second multiplier 200, to provide thereby a resultant BPSK modulation signal with constant envelope characteristic, as seen by the waveform of Figure 4(t). Hence, the resultant BPSK output signal with constant envelope can be precisely amplified even in C-class operation in the power amplifier 220, without any signal distortion due to undesirable fluctuation of an amplitude level in the vicinity of its phase shifting position. This enables the reception of quality data for a receiving party upon transmission of a BPSK modulation signal in a digital telecommunication system.

As is apparent from the foregoing description, the illustrated embodiment of the present invention makes it possible to amplify given digital data with constant and adequate level, even in the phase shifting locations or their vicinity, for example, at zero-crossing positions of a BPSK modulation signal in a digital transmission system, so it improves the transmission efficiency of digital telecommunication owing to reception and transmission of quality data.

While the foregoing provides a full and complete disclosure of a preferred embodiment of the present invention, various modifications, alternate constructions and equivalents thereof may be employed without departing from the scope of the invention. Therefore, the above description and illustration should not be construed as limiting the scope of the invention, which is defined by the appended claims.

## Claims

1. A biphase shift keying (BPSK) modulation circuit for a digital data transmission system, the circuit comprising:

   a clock input (100) for receiving a system clock;

   data generation means (10) for providing digital data in synchronism with the system clock;

   data conversion means (20), connected to receive the system clock and the digital data from the data generation means (10) to produce both in-phase and quadra-phase signal components from the digital data; and

   modulation means (30), for providing a phase modulation signal of constant envelope on a given carrier wave signal for digital data transmission, the circuit being characterised in that the digital data from the data generation means (10) are random digital data from a random data generation means (120), the data conversion means (20) comprises a shift register (130) connected to receive the system clock and the digital data, for providing in parallel a plurality of digital data sequentially shifted from the digital data of the data generation means in synchronism with the system clock, a first resistance array (140), connected to receive the parallel digital data from said shift register (130), for providing an in-phase signal component produced in dependence upon multiplication and adding operations therein, said first resistance array (140) having a plurality of resistors (R1-R8) each coupled to corresponding ones of outputs (D0-D7) of said shift register (130), a gate array (150) having a plurality of logic gates (G1-G4), each gate being connected to receive a pair of selected two inputs of said shift register (130), and a second resistance array (160) connected to receive an output of said gate array (150), for providing a quadra-phase signal component produced in dependence upon multiplication and adding operations therein, said second resistance array (160) having a plurality of resistors (R10-R13) each coupled to corresponding ones of the logic gates (G1-G4) of said gate array (150), and said in-phase signal component is processed by said modulation means (30) in double-balanced modulation with the carrier-wave and said quadra-phase signal component is processed in single-balanced modulation with a phase-shifted signal of the carrier-wave, and said double-balanced modulation signal and said single-balanced modulation signal are added to each other.

2. A BPSK modulation circuit according to claim 1, wherein said logic gates (G1 - G4) each comprise an EXCLUSIVE-OR logic gate.

3. A BPSK modulation circuit according to any of claims 1 and 2, wherein said modulation means (30) comprises:

   a first multiplier (180) connected to receive the in-phase signal component, for providing a double-balanced modulation component on the basis of the carrier-wave;

   a phase shifter (190) connected to receive the carrier-wave for phase shifting the carrier-wave;

   a second multiplier (200) connected to receive the quadra-phase signal component, for providing a single-balanced modulation component on the basis of the phased-shifted carrier-wave; and

   an adder (210) connected to add both the outputs of the first and second multipliers (180,200), for producing therefrom a resultant biphase shift keying modulation signal.

4. A BPSK modulation circuit according to any of the preceding claims, further comprising an amplifier (220) for amplifying the biphase shift keying modulation signal from said modulation means (30).

5. A BPSK modulation circuit according to claim 4, further comprising an antenna device (ANT) coupled to the amplifier (220), for transmission of the modulation signal into the air.

6. A BPSK modulation circuit according to claim 4 or 5, wherein said amplifier (220) is of a C-class operation mode.

7. A BPSK modulation circuit according to claim 3 or to claim 3 together with any of claims 4 to 6, wherein said phase shifter (190) is arranged to perform a 90-degrees phase shifting operation on an input signal.

8. A BPSK modulation circuit according to claim 2 or to claim 2 together with any of claims 3 to 7, wherein each resistance of said first and second resistance arrays (140, 160) is arranged to meet the following relationship:

$$[I(t)]^2 + [Q(t)]^2 = C$$

wherein,

I(t) represents the in-phase signal component,
Q(t) represents the quadra-phase signal component, and
C is a given constant.

9. A BPSK modulation circuit according to any of the preceding claims, further comprising a carrier-wave generation means (170) connected to said modulation means (30) for providing the carrier-wave.


**Patentansprüche**

1. Schaltkreis für binäre Phasensprungmodulation (BPSK) für ein digitales Datenübertragungssystem, umfassend:

ein Takteingang (100) zum Empfangen eines Systemtaktes;

eine Datenerzeugungseinrichtung (10) zum Bereitstellen digitaler Daten synchron mit dem Systemtakt;

eine Datenumwandlungseinrichtung (20), die so verbunden ist, daß sie den Systemtakt und die digitalen Daten von der Datenerzeugungseinrichtung (10) empfängt, um von den digitalen Daten sowohl gleichphasige als auch gegenphasige Signalkomponenten zu erzeugen; und

eine Modulationseinrichtung (30) zur Bereitstellung eines Phasenmodulationssignales einer konstanten Einhüllenden auf einem gegebenen Trägerwellensignal für digitale Datenübertragung, wobei der Schaltkreis **dadurch gekennzeichnet** ist, daß die digitalen Daten von der Datenerzeugungseinrichtung (10) Zufallsdigitaldaten von einer Zufallsdatenerzeugungseinrichtung (120) sind, daß die Datenumwandlungseinrichtung (20) ein Schieberegister (130), das so verbunden ist, daß es den Systemtakt und die digitalen Daten empfängt, um eine Vielzahl von digitalen Daten parallel bereitzustellen, die gegenüber den digitalen Daten der Datenerzeugungseinrichtung synchron mit dem Systemtakt sequentiell verschoben sind, ein erstes Widerstandsfeld (140), das so verbunden ist, daß es die parallelen digitalen Daten vom Schieberegister (130) empfängt, um eine gleichphasige Signalkomponente bereitzustellen, die darin in Abhängigkeit von Multiplikations- und Additionsoperationen erzeugt wird, wobei das erste Widerstandsfeld (140) eine Vielzahl von Widerständen (R1-R8) hat, von denen jeder zu einem entsprechenden Ausgang (D0-D7) des Schieberegisters (130) gekoppelt ist, einen Gate Array (150) mit einer Vielzahl von Logikgattern (G1-G4), von denen jedes Gatter so verbunden ist, daß es ein Paar von zwei ausgewählten Eingängen des Schieberegisters (130) empfängt, und ein zweites Widerstandsfeld (160) umfaßt, das so verbunden ist, daß es eine Ausgabe des Gate Arrays (150) empfängt, um eine gegenphasige Signalkomponente bereitzustellen, die darin in Abhängigkeit von Multiplikations- und Additionsoperationen erzeugt wird, wobei das zweite Widerstandsfeld (160) eine Vielzahl von Widerständen (R10-R13) hat, von denen jeder mit einem entsprechenden Logikgatter (G1-G4) des Gate Arrays (150) gekoppelt ist, und daß die gleichphasige Signalkomponente von der Modulationseinrichtung (30) in Doppelgegentaktmodulation mit der Trägerwelle verarbeitet wird, und daß die gegenphasige Signalkomponente in Einzelgegentaktmodulation mit einem phasenverschobenen Signal der Trägerwelle verarbeitet wird, und daß das Doppelgegentaktmodulationssignal und das Einzelgegentaktmodulationssignal miteinander addiert werden.

2. Schaltkreis für binäre Phasensprungmodulation (BPSK) nach Anspruch 1, worin die Logikgatter (G1-G4) jeweils ein EXKLUSIV-ODER-Logikgatter umfaßt.

3. Schaltkreis für binäre Phasensprungmodulation (BPSK) nach einem der Ansprüche 1 und 2, worin die Modulationseinrichtung (30) umfaßt:

einen ersten Multiplizierer (180), der so verbunden ist, daß er die gleichphasige Signalkomponente empfängt, um eine Doppelgegentaktmodulationskomponente auf der Basis der Trägerwelle bereitzustellen;

einen Phasenschieber (190), der so verbunden ist, daß er die Trägerwelle empfängt, um die Phase der Trägerwelle zu verschieben;

einen zweiten Multiplizierer (200), der so verbunden ist, daß er die gegenphasige Signalkomponente empfängt, um eine Einzelgegentaktmodulationskomponente auf der Basis der phasenverschobenen Trägerwelle bereitzustellen; und

einen Addierer (210), der so verbunden ist, daß er die Ausgänge des ersten und des zweiten Multiplizierers (180, 200) miteinander addiert, um davon ein sich ergebendes binäres Phasensprungmodulationssignal zu erzeugen.

4. Schaltkreis für binäre Phasensprungmodulation (BPSK) nach einem der vorangegangenen Ansprüche, weiterhin umfassend einen Verstärker (220) zur Verstärkung des binären Phasensprungmodulationssignales von der Modulationseinrichtung (30).

5. Schaltkreis für binäre Phasensprungmodulation (BPSK) nach Anspruch 4, weiterhin umfassend eine Antennenvorrichtung (ANT), die an den Verstärker (220) gekoppelt ist, zur Abstrahlung des Modulationssignales in die Luft.

6. Schaltkreis für binäre Phasensprungmodulation (BPSK) nach Anspruch 4 oder 5, wobei der Verstärker (220) ein Verstärker der Klasse-C-Betriebsart ist.

7. Schaltkreis für binäre Phasensprungmodulation (BPSK) nach Anspruch 3 oder nach Anspruch 3 zusammen mit einem der Ansprüche 4 bis 6, wobei der Phasenschieber (190) so eingerichtet ist, daß er an einem Eingangssignal eine Phasenverschiebung um 90° durchführt.

8. Schaltkreis für binäre Phasensprungmodulation (BPSK) nach Anspruch 2 oder nach Anspruch 2 zusammen mit einem der Ansprüche 3 bis 7, wobei jeder Widerstand des ersten und zweiten Widerstandsfeldes (140, 160) so eingerichtet ist, daß die folgende Beziehung zutrifft:

$$[I(t)]^2 + [Q(t)]^2 = C$$

worin

I(t) die gleichphasige Signalkomponente darstellt,
Q(t) die gegenphasige Signalkomponente darstellt, und
C eine gegebene Konstante ist.

9. Schaltkreis für binäre Phasensprungmodulation (BPSK) nach einem der vorangegangenen Ansprüche, weiterhin umfassend eine Trägerwellenerzeugungseinrichtung (170), die mit der Modulationseinrichtung (30) verbunden ist, um eine Trägerwelle bereitzustellen.

**Revendications**

1. Circuit de modulation de phase à deux états (BPSK - Binary Phase Shift Keying) pour un système de transmission de données numériques, le circuit comportant:

une entrée d'horloge (100) pour recevoir un signal d'horloge du système;
un moyen de génération de données (10) pour fournir des données numériques en synchronisme avec l'horloge du système;
un moyen de conversion de données (20) connecté pour recevoir le signal d'horloge du système et les données numériques provenant du moyen de génération de données (10) pour produire à partir des données numériques deux composantes de signal en phase et en quadrature de phase; et
un moyen de modulation (30) pour fournir un signal de modulation de phase d'enveloppe constante sur un signal d'onde porteuse donné pour la transmission de données numériques, le circuit étant caractérisé en ce que les données numériques provenant du moyen de génération de données (10) sont des données numériques aléatoires provenant d'un moyen de génération de données aléatoires (120), le moyen de conversion de données (20) comporte un registre à décalage (130) connecté pour recevoir le signal d'horloge du système et les données numériques, pour fournir en parallèle une pluralité de données numériques séquentiellement décalées par rapport aux données numériques du moyen de génération de données en synchronisme avec l'horloge du système, un premier ensemble résistif (140) connecté pour recevoir les données numériques en parallèle provenant dudit registre à décalage (130), pour fournir une composante de signal en phase résultant des opérations de multiplication et d'addition effectuées, ledit premier ensemble résistif (140) comportant une pluralité de résistances (R1 à R8) chacune reliée à une sortie correspondante (D0 à D7) dudit registre à décalage (130), un ensemble de portes (150) comportant une pluralité de portes logiques (G1 à G4), chaque porte étant connectée pour recevoir une paire de deux entrées sélectionnées dudit registre à décalage (130), et un deuxième ensemble résistif (160) connecté pour recevoir une sortie dudit ensemble de portes (150), pour fournir une composante de signal en quadrature de phase résultant des opérations de multiplication et d'addition effectuées, ledit deuxième ensemble résistif (160) comportant une pluralité de résistances (R10 à R13) chacune reliée à une porte logique correspondante (G1 à G4) dudit ensemble de portes (150), et ladite composante de signal en phase est traitée par ledit moyen de modulation (30) en modulation symétrique double avec l'onde porteuse et ladite composante de signal en quadrature de phase est traitée en modulation symétrique simple avec un signal d'onde porteuse déphasé, et lesdits signaux de modulation symétrique double et symétrique simple sont additionnés.

2. Circuit de modulation BPSK selon la revendication 1, dans lequel lesdites portes logiques (G1 à G4) comportent chacune une porte logique OU EXCLUSIF.

3. Circuit de modulation BPSK selon l'une quelconque des revendications 1 ou 2, dans lequel ledit moyen de modulation (30) comporte:

un premier multiplicateur (180) connecté pour recevoir la composante de signal en phase, pour fournir une composante de modulation symétrique double en fonction de l'onde porteuse;
un circuit de déphasage (190) connecté pour recevoir l'onde porteuse afin de la déphaser;
un deuxième multiplicateur (200) pour recevoir la composante de signal en quadrature de phase, pour fournir une composante de modulation symétrique simple en fonction de l'onde porteuse décalée en phase; et
un additionneur (210) connecté pour recevoir les deux signaux de sortie des premier et deuxième multiplicateurs (180, 200), pour fournir à partir de ces signaux un signal résultant de modulation de phase à deux états.

4. Circuit de modulation BPSK selon l'une quelconque des revendications précédentes, comportant en outre un amplificateur (220) pour amplifier le signal de modulation de phase à deux états provenant dudit moyen de modulation (30).

5. Circuit de modulation BPSK selon la revendication 4, comportant en outre un dispositif d'antenne (ANT) relié à l'amplificateur (220), pour la transmission du signal de modulation par voie aérienne.

6. Circuit de modulation BPSK selon la revendication 4 ou 5, dans lequel le mode de fonctionnement dudit amplificateur (220) est de classe C.

7. Circuit de modulation BPSK selon la revendication 3 ou selon la revendication 3 associée à l'une quelconque des revendication 4 à 6, dans lequel ledit circuit de déphasage (190) est agencé de façon à effectuer une opération de déphasage de 90 degrés sur un signal d'entrée.

8. Circuit de modulation BPSK selon la revendication 2 ou la revendication 2 associée à l'une quelconque des revendications 3 à 7, dans lequel chacune des résistances desdits premier et deuxième ensembles résistifs (140, 160) est agencée pour satisfaire la relation:

$$(I(t))^2 + (Q(t))^2 = C$$

où

I(t) représente la composante de signal en phase,
Q(t) représente la composante de signal en quadrature de phase, et
C est une constante donnée.

9. Circuit de modulation BPSK selon l'une quelconque des revendications précédentes, comportant en outre un moyen de génération d'onde porteuse (170) connecté audit moyen de modulation (30) pour fournir l'onde porteuse.

(PRIOR ART)
FIG. 1

FIG. 2

9

FIG. 3

EP 0 480 674 B1

FIG. 4